# EUROPÄISCHE PATENTSCHRIFT

(11) **EP 0 863 230 B1**
(45) Veröffentlichungstag und Bekanntmachung des Hinweises auf die Patenterteilung: **05.07.2000**
(21) Anmeldenummer: 98100962.4
(22) Anmeldetag: 21.01.1998
(51) Int. Cl.: C30B 15/00, C30B 15/30

(54) **Vorrichtung zur Handhabung schwerer Bauteile einer in einem Traggestell abgestützten Kristallziehmaschine nach dem Czochralski-Verfahren**
Apparatus for handling heavy parts of Czochralski crystal pulling apparatus supported in a frame structure
Dispositif pour manipuler des éléments lourds d'un appareillage pour le tirage de monocristaux selon le procédé Czochralski supporté dans une structure de support

(30) Priorität: 06.03.1997 DE 19709212
(43) Veröffentlichungstag der Anmeldung: 09.09.1998
(73) Patentinhaber: Balzers und Leybold Deutschland Holding AG, 63450 Hanau (DE); Leybold Systems GmbH, 63450 Hanau (DE)
(72) Erfinder: Schulmann, Winfried, 63801 Kleinostheim (DE); Wenske, Udo, 63486 Bruchköbel (DE); Kaiser, Helmut, Dr., 63486 Bruchköbel (DE); Thimm, Franz, 63755 Alzenau (DE)

(56) Entgegenhaltungen:
- EP-A- 0 460 477

## Beschreibung

Die Erfindung bezieht sich auf eine Vorrichtung zur Handhabung schwerer Bauteile einer in einem Traggestell abgestützten Kristallziehmaschine nach dem Czochralski-Verfahren, bei der der auf einem Tragbolzen abgestützte Tiegel in der Ziehkammer durch Wärmestrahlung eines den Tiegel umgebenden Heizelements erhitzt wird und der Kristall mit einer Zieheinrichtung oberhalb der Schmelze von der Schmelzenoberfläche aus nach oben in eine absperrbare Schleusenkammer gezogen wird, mit einer horizontal angeordneten, in der Höhe verfahrbaren und um die Senkrechte, vorzugsweise um ein Tragbein des Traggestells schwenkbaren Tragbalken.

Bei dem bekannten Ziehprozeß wird der Kristall aus einer in einem Tiegel befindlichen Schmelze unter Vakuum oder unter Schutzgas bei vermindertem Druck aus der Schmelze gezogen, wobei der Tiegel in einer durch ein Traggestell abgestützten Vakuumkammer auf einem Tiegeltragbolzen angeordnet und durch Wärmestrahlung eines Heizelementes erhitzt wird und ein Ziehelement oberhalb der Schmelze vorgesehen ist, von der Schmelzenoberfläche aus nach oben zu in eine abtrennbare Schleusenkammer gezogen.

Nach Abtrennen des Kristalls von dem Ziehantrieb durch Brechen oder Durchschneiden des Impflings kann der Kristall aus der Schleusenkammer entnommen werden. Für kleinere Kristalldurchmesser bis etwa 150 mm Durchmesser kann dies noch mit Hand erfolgen. Für größere Durchmesser sind Hilfseinrichtungen erforderlich, um das Gewicht des Kristalls vor dem Durchtrennen des Impflings aufzufangen und die seitliche Entnahme aus der Schleusenkammer zu ermöglichen. Mit zunehmendem Kristalldurchmesser vergrößern sich auch die Abmessungen und Gewichte einer Kristallziehanlage mit Ihren Einbauten. Zum Ziehen eines Kristalls mit 300 mm Durchmesser werden Quarztiegel mit einem Chargengewicht bis 250 kg eingesetzt. Der Ein- und Ausbau solcher Tiegel kann nur mit mechanischen Hilfsmitteln erfolgen. Entsprechendes gilt für alle anderen Bauteile und Einbauten der Anlage, die nicht mehr von Hand bewegt werden können.

Es gibt bereits eine Reihe von Hilfsvorrichtungen, die sich aber ausschließlich mit der Entnahme des Kristalls befassen.

Es wurden z. B. Stützelemente vorgeschlagen, die mit Hilfe eines Schwenkventiles, das die Schleusenkammer von der Ziehkammer trennt, in den Boden eines an der Schleusentür befestigten, den Kristall umschließenden Rohres mit einem im Vergleich zum Kristall größeren Durchmesser einführt, so daß das Gewicht des Kristalls nach Absenken auf die Stützelemente aufgefangen wird und der Kristall im Rohr mit der Tür ausgeschwenkt werden kann (DE-A-196 08 374, veröffentlicht am 11.09.97).

Es wurde auch bereits eine seitlich trennbare Entkopplungsvorrichtung mit einem am Ziehelement befestigten Kuppelring und einem pilzförmigen Kopfteil, an dem der Kristall hängt, vorgeschlagen (DE-A 195 38 857, veröffentlicht am 24/04/97).

In der US 4,350,560 ist die Kristallentnahme durch seitliches Wegschwenken der Schleusenkammer mit dem Kristall und anschließendes Absenken des Kristalls durch den freien Boden der Schleusenkammer nach unten in einen Vorratsbehälter gelöst.

Der vorliegenden Erfindung liegt die Aufgabe zugrunde, eine Vorrichtung für das Ein- und Ausbauen schwerer Bauteile einer Kristallziehanlage, beispielsweise des Tiegels, der Heizeinrichtung, der Tiegelabdeckung oder auch der Vakuumkessel so auszuführen, daß diese unterschiedlichen Formteile mit einer einzigen Vorrichtung bewegt werden können und darüber hinaus die Entnahme des Kristalls mit der Vorrichtung möglich ist.

Gemäß der vorliegenden Erfindung wird die Aufgabe dadurch gelöst, daß die Vorrichtung eine vorzugsweise an einem der Standbeine des die Kristallziehanlage aufnehmenden Tragwerkes parallel zur Hauptachse der Ziehkammer sich erstreckende Tragschiene mit einem gegenüber dieser horizontal erstreckenden, in der Höhe verstellbaren und um die Senkrechte schwenkbaren Tragbalken aufweist, der zur Aufnahme von Kesselteilen, Bauteilen oder mindestens einer Greifzange mit Halteklauen für die Anlenkung verschiedener Hilfseinrichtungen versehen ist und einen quer zum Tragbalken verfahrbaren Schlitten besitzt, mit dem bei geöffneter Schleusenkammer der Kristall gegriffen und entnommen werden kann.

Weitere Einzelheiten und Merkmale der Erfindung sind in den Unteransprüchen näher gekennzeichnet und beschrieben.

Die Erfindung läßt die verschiedensten Ausführungsmöglichkeiten nach Art eines Baukastensystems zu. Eine Kombination ist in den anhängenden Zeichnungen schematisch dargestellt, und zwar zeigen:
- Fig. 1: eine in einem Traggestell montierte Kristallziehmaschine mit der erfindungsgemäßen Vorrichtung in schematischer Darstellung;
- Fig. 2: die Vorrichtung in der Ausführung zur Kristallentnahme, Aufnahme des Ziehkessels und Anlenkung einer Greifzange;
- Fig. 3: den Tragbalken mit angelenkter Kristallentnahme;
- Fig. 4: den Tragbalken mit angelenktem Ziehkessel und
- Fig. 5: den Tragbalken mit angelenkter Greifzange.

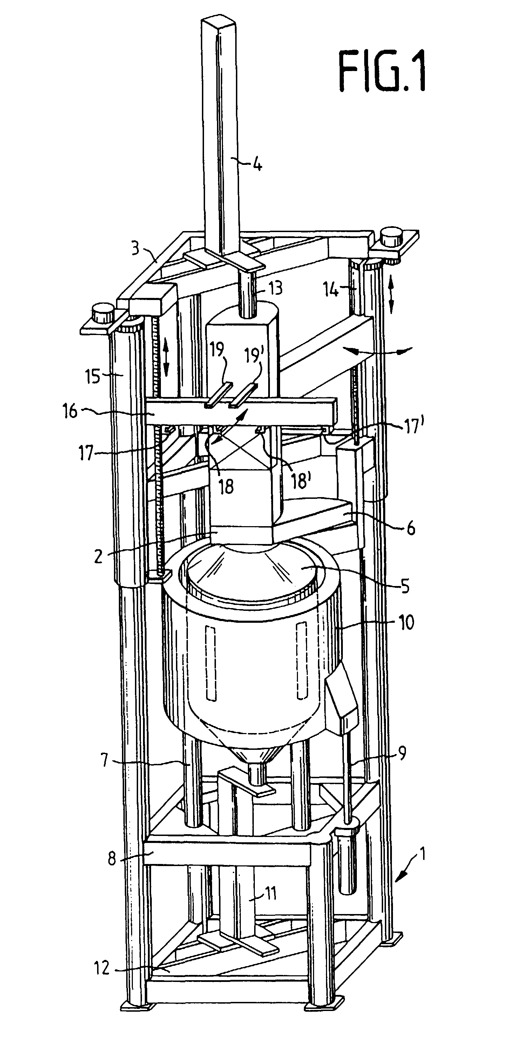

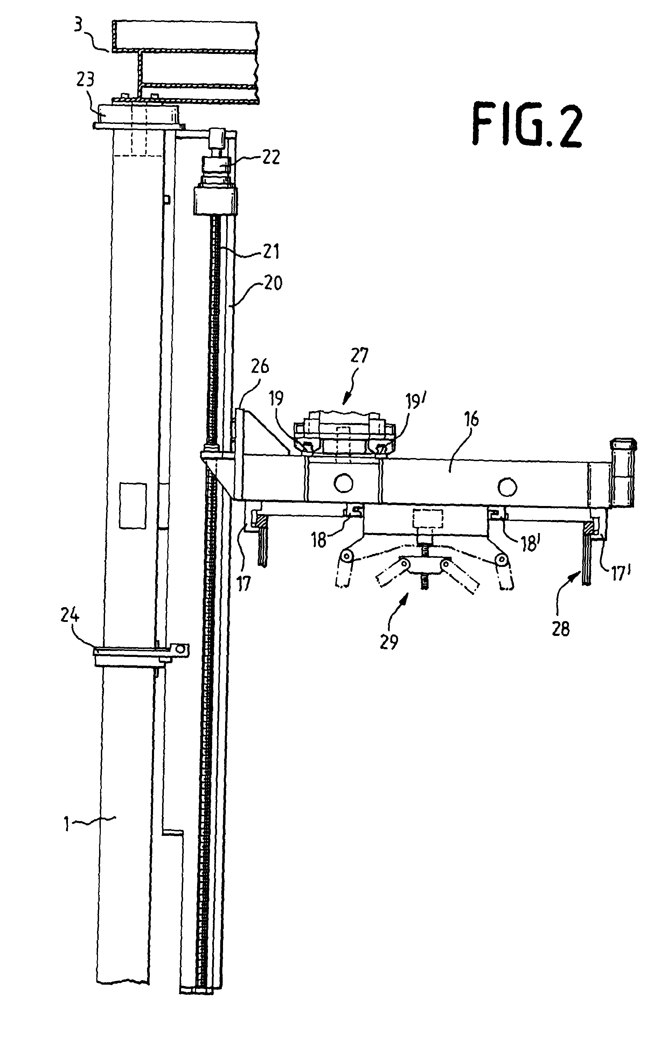

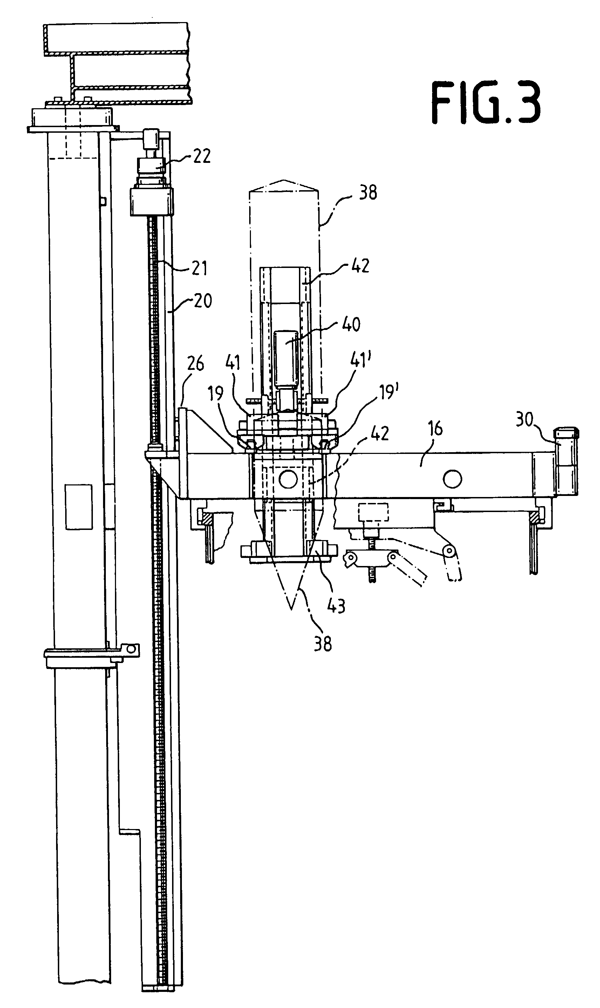

In Fig. 1 ist in bekannter Weise eine in ein Traggestell 1 montierte Kristallziehanlage dargestellt. Parallel zu einem Standbein ist die Handlingseinrichtung 15, schwenkbar um die Senkrechte und mittels Spindelantrieb höhenverstellbar dargestellt. Die Handlingseinrichtung 15 ist in Fig. 2 genauer detailliert. An einem Standbein 1 des Traggestells ist eine Tragschiene 20 mittels drehbarer Haltevorrichtungen 23 und 24 um die Senkrechte schwenkbar angelenkt. Über die mit dem Motor 22 angetriebene Spindel 21 wird ein Fahrschlitten 26 über die fest mit dem Fahrschlitten verbundene Spindelmutter 25 entlang der Tragschiene bewegt. Senkrecht zur Tragschiene 20 ist mit dem Fahrschlitten ein als Hohlkörper ausgebildeter Tragbalken 16 verbunden, an dem Befestigungselemente in Form von Halteklauen (17, 17' und 18, 18') zum Anlenken eines Flansches von einem Kesselteil 28 oder eines Halteflansches für einen Greifer 29 und etwa quer zur Längsachse des Tragbalkens 16 verlaufende Profilschienen (19, 19') für die Aufnahme eines Tragschlittens 27. Der Tragschlitten 27 läßt sich nach Fig. 3 mit einer Kristallentnahmevorrichtung verbinden, die über einen nicht näher dargestellten Linearantrieb horizontal verfahrbar ist. Bei der Entnahme eines Kristalls fährt der Schlitten bei geöffneter Schleusenkammer in die Entnahmeposition, in der die Spitze des Kristalls bereits durch den Aufnahmeflansch 43 hindurchgreift. Zum Einfädeln ist der Aufnahmeflansch 43 als offener Ring ausgeführt. Nach Absenken des Kristalls 38 fängt der Aufnahmeflansch 43 das Gewicht des Kristalls 38 auf. Über den mit einer Doppelspindel verbundenen Antriebsmotor 40 lassen sich zwei Greifklauen 41,41' betätigen, die den Kristall 38 backenförmig umgreifen und so den Kristall sicher und schonend im Anschlag zur Stütze 42 arretiert halten. Nach Trennung des Kristalls 38 von dem Impfling kann er durch seitliches Verfahren und Ausschwenken in die vorgesehene Entnahmeposition gefahren werden.

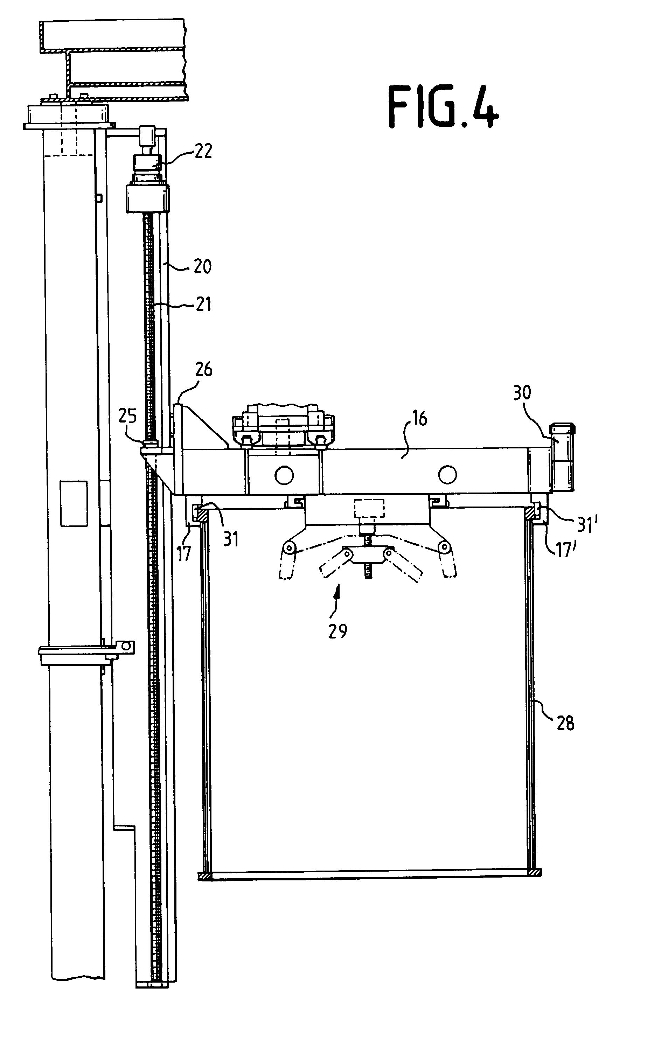

Fig. 4 zeigt die Wirkweise der Handlingseinrichtung am Beispiel der Aufnahme eines Kesselteiles. Der Tragbalken 16 mit seinen klauenförmigen Haltegriffen 17, 17' über einen Kesselflansch durch horizontales Schwenken eingefahren. Eine im Tragbalken vorgesehene Kinematik sorgt dafür, daß die Verbindung Halteklaue, Flansch mittels Verriegelungsbolzen 31, 31' gesichert wird. Dazu werden Bolzen mittels einer vom Motor 30 angetriebenen horizontalen Welle in die jeweiligen Verriegelungspositionen bewegt, so daß ein seitliches Verrutschen von Flansch und Halteklaue unmöglich ist.

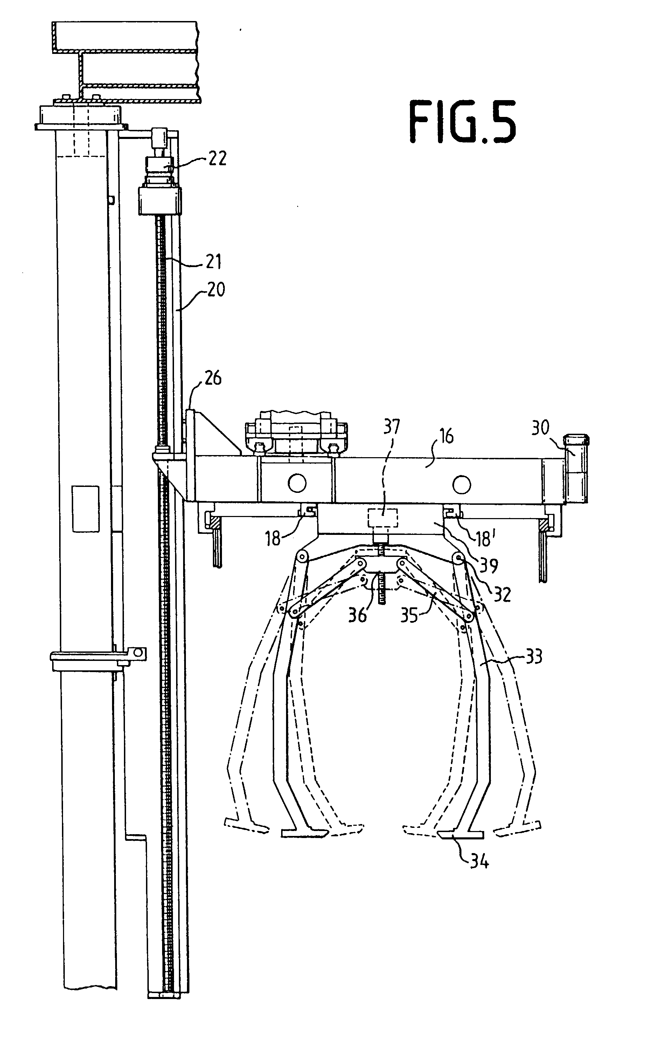

In Fig. 5 ist an den beispielhaft gezeigten inneren Halteklauen 18, 18' ein Halteflansch 39 angelenkt, der einen mehrarmigen Greifer hält. Dieser besteht aus mehreren einarmigen Greifarmen 33, die am Umfang des Halteflansches 39 um den Drehpunkt 32 schwenkbar aufgehängt sind und an ihrem Greifende mit Vorsprüngen oder Nasen für das wahlweise innen- oder außenseitige Greifen von entsprechenden Bauteilen, wie Heizer oder Tiegel, versehen sind. Die Greifarme sind mittels der Streben 35 an der Spindelmutter 36 angelenkt, so daß sie über den Antrieb 37 in die Schließ- oder Öffnungsstellung bewegt werden können. Hat z. B. der konzentrisch zum Tiegel angeordnete Graphitheizer entsprechende Durchbrüche, kann der Greifer durch Absenken der Spindelmutter in die Halteposition mit gespreizten Greifarmen gefahren werden, so daß die außenseitigen Nasen in die Öffnungen des Heizers eingreifen und so den schweren Heizer durch Hochfahren des Tragbalkens hochheben.

Die angeführten Ausführungen sind nur beispielhaft beschrieben. Eine Vielzahl von Hilfseinrichtungen sind in Verbindung mit der erfindungsgemäßen Handlingseinrichtung vorstellbar.

### Bezugszeichenliste

- 1: Gestell
- 2: Schleuse
- 3: Abschlußrahmen
- 4: Ziehvorschub
- 5: Kesselteile, Vakuumkammer
- 6: Schleusenventil
- 7: Stütze
- 8: Querverbindung
- 9: Hebe-/Senkeinrichtung
- 10: Magnet
- 11: Tiegelvorschub
- 12: Querverbindung
- 13: Balg
- 14: Handlingseinrichtung
- 15: Handlingseinrichtung
- 16: Tragbalken
- 17, 17': Halteklauen
- 18, 18': Halteklauen
- 19, 19': Profilschienen
- 20: Tragschiene
- 21: Spindel
- 22: Spindelantrieb
- 23: Drehhalterung
- 24: Drehlager
- 25: Spindelmutter
- 26: Schlitten
- 27: Schlitten für Kristallentnahme
- 28: Kessel
- 29: Greifer
- 30: Motor
- 31: Verriegelungsbolzen
- 32: Drehpunkt
- 33: Greifarm
- 34: Greifendstück
- 35: Strebe
- 36: Spindelmutter
- 37: Spindelantrieb
- 38: Kristall
- 39: Halteflansch
- 40: Spindelantrieb
- 41, 41': Greifklauen
- 42: Anschlag
- 43: Aufnahmeflansch

## Patentansprüche

1. Vorrichtung zur Handhabung schwerer Bauteile einer in einem Traggestell abgestützten Kristallziehmaschine nach dem Czochralski-Verfahren, bei der der auf einem Tragbolzen abgestützte Tiegel in der Ziehkammer durch Wärmestrahlung eines den Tiegel umgebenden Heizelements erhitzt wird und der Kristall mit einer Zieheinrichtung oberhalb der Schmelze von der Schmelzenoberfläche aus nach oben in eine absperrbare Schleusenkammer gezogen wird, mit einer horizontal angeordneten, in der Höhe verfahrbaren und um die Senkrechte, vorzugsweise um ein Tragbein des Traggestells schwenkbaren Tragbalken, **dadurch gekennzeichnet,** daß der Tragbalken mit Halteklauen zur Aufnahme von Anlagenbauteilen oder an Flanschringen befestigten Hilfseinrichtungen, z. B. einem Greifer, ausgerüstet ist, mit deren Hilfe wahlweise Bauteile aufgenommen und abgesetzt werden können, und daß quer zu dem Tragbalken Profilschienen als Träger eines verfahrbaren Schlittens angebracht sind, an dem eine Aufnahme zum Greifen und Halten des Kristalls befestigbar ist.

2. Vorrichtung nach Anspruch 1, **dadurch gekennzeichnet,** daß die Aufnahme zum Halten und Greifen des Kristalls aus einem geschlitzten Haltering besteht, auf den sich das konische Kristallende nach dem Absenken abstützt, und über dem Haltering schwenkbare Greifbacken angeordnet sind.

3. Vorrichtung nach Anspruch 1, **dadurch gekennzeichnet,** daß der Greifer mit auswechselbaren Greifarmen versehen ist.

4. Vorrichtung nach Anspruch 1, **dadurch gekennzeichnet,** daß die Greifarme beidseitige Endstücke oder Nasen aufweisen.

5. Vorrichtung nach Anspruch 1, **dadurch gekennzeichnet,** daß der Tragbalken mit Verriegelungselementen ausgerüstet ist, die die aufgenommenen Bauteile in den Halteklauen oder den verfahrbaren Schlitten sichern.

6. Vorrichtung nach Anspruch 1, **dadurch gekennzeichnet,** daß der Tragbalken mit Sensoren ausgerüstet ist, die den Zustand der lösbaren Halteverbindungen anzeigen.

## Claims

1. A device for handling heavy components of a crystal pulling machine supported in a support frame according to the Czochralski method, in which the crucible supported on a support bolt is heated in the pulling chamber by thermal radiation of a heating element surrounding the crucible and the crystal is pulled upwards using a pulling device above the melt from the melt surface into a closable lock chamber, with a horizontally arranged support beam, which is displaceable in its height and is pivotable about the vertical, preferably about a support leg of the support frame, characterised in that the support beam is equipped with holding claws for receiving apparatus components or auxiliary devices secured to flange rings, e.g. a gripper, with the aid of which holding claws components can be selectively received and deposited, and profile rails are fitted transversely to the support beam as supports of a displaceable carriage, to which a receiving element can be secured for grasping and holding the crystal.

2. A device according to claim 1, characterised in that the receiving element for holding and grasping the crystal is formed by a slotted holding ring, on which the conical crystal end is supported after lowering, and pivotable gripping jaws are arranged above the holding ring.

3. A device according to claim 1, characterised in that the gripper is provided with replaceable gripper arms.

4. A device according to claim 1, characterised in that the gripper arms comprise end elements or noses on both sides.

5. A device according to claim 1, characterised in that the support beam is equipped with locking elements, which secure the received components in the holding claws or the displaceable carriage.

6. A device according to claim 1, characterised in that the support beam is equipped with sensors, which display the state of the releasable holding connections.

## Revendications

1. Appareil pour la manutention de composants lourds dans une machine de tirage de cristaux supportée dans un châssis de support, selon le procédé de Czochralski, dans lequel le creuset supporté sur une barre de support est réchauffé dans la chambre de tirage par rayonnement thermique d'un élément chauffant qui entoure le creuset, et le cristal est tiré, au moyen d'un dispositif de tirage au-dessus de la matière en fusion, depuis la surface de la matière en fusion et vers le haut jusque dans une chambre de sas susceptible d'être refermée, et comprenant une poutre de support agencée horizontalement, susceptible d'être déplacée en hauteur, et d'être pivotée autour de la verticale, de préférence autour d'un pied du châssis de support, caractérisé en ce que la poutre de support est équipée de griffes de maintien afin de recevoir des composants, ou de dispositifs auxiliaires fixés sur des anneaux à bride, par exemple d'un dispositif de saisie, à l'aide duquel des composants peuvent être pris et déposés au choix, et en ce que des rails profilés sont montés perpendiculairement à la poutre de support, à titre de supports pour un chariot déplaçable, sur lequel un moyen de réception pour la saisie et le maintien du cristal est susceptible d'être fixé.

2. Appareil selon la revendication 1, caractérisé en ce que le moyen de réception pour la saisie et le maintien du cristal est constitué par une bague de maintien fendue, sur laquelle s'appuie l'extrémité conique du cristal après l'abaissement, et au-dessus de laquelle sont agencées des mâchoires de saisie pivotantes.

3. Appareil selon la revendication 1, caractérisé en ce que le dispositif de saisie est équipé de bras de saisie interchangeables.

4. Appareil selon la revendication 1, caractérisé en ce que les bras de saisie présentent des pièces d'extrémité ou des doigts sur les deux côtés.

5. Appareil selon la revendication 1, caractérisé en ce que la barre de support est équipée d'éléments de verrouillage, qui bloquent les composants reçus dans les griffes de maintien ou dans le chariot déplaçable.

6. Appareil selon la revendication 1, caractérisé en ce que la barre de support est équipée de détecteurs qui indiquent l'état des liaisons de maintien détachables.
